(19) Europäisches Patentamt / European Patent Office / Office européen des brevets

(11) **EP 1 766 338 B1**

(12) **FASCICULE DE BREVET EUROPEEN**

(45) Date de publication et mention de la délivrance du brevet:
**16.04.2014 Bulletin 2014/16**

(21) Numéro de dépôt: **05789999.9**

(22) Date de dépôt: **07.07.2005**

(51) Int Cl.:
*G01D 18/00* (2006.01)     *G01D 21/00* (2006.01)

(86) Numéro de dépôt international:
**PCT/FR2005/050548**

(87) Numéro de publication internationale:
**WO 2006/008417 (26.01.2006 Gazette 2006/04)**

(54) **PROCEDE DE TEST D'UN SYSTEME DE MESURE A CAPACITE VARIABLE**

VERFAHREN ZUM TESTEN EINER MESSVORRICHTUNG MIT VARIABLER KAPAZITÄT

TEST METHOD FOR A VARIABLE CAPACITANCE MEASURING SYSTEM

(84) Etats contractants désignés:
**AT BE BG CH CY CZ DE DK EE ES FI FR GB GR HU IE IS IT LI LT LU LV MC NL PL PT RO SE SI SK TR**

(30) Priorité: **09.07.2004 FR 0451489**

(43) Date de publication de la demande:
**28.03.2007 Bulletin 2007/13**

(73) Titulaire: **Commissariat à l'Énergie Atomique et aux Énergies Alternatives**
**75015 Paris (FR)**

(72) Inventeurs:
• **DELORME, Nicolas**
**F-38000 GRENOBLE (FR)**
• **CONDEMINE, Cyril**
**38140 IZEAUX (FR)**
• **BELLEVILLE, Marc**
**F-38120 SAINT EGREVE (FR)**

(74) Mandataire: **Ahner, Philippe et al**
**BREVALEX**
**95 rue d'Amsterdam**
**75378 Paris Cedex 8 (FR)**

(56) Documents cités:
**GB-A- 2 239 096     US-A- 5 103 667**
**US-A- 5 351 519**

## Description

## DOMAINE TECHNIQUE

La présente invention concerne un procédé de test d'un système de mesure à capacité variable.

Le domaine de l'invention est celui des microsystèmes comprenant un capteur capacitif et un circuit de traitement de l'information délivré par ce capteur.

## ÉTAT DE LA TECHNIQUE ANTÉRIEURE

De tels microsystèmes à capteur capacitif ne sont, dans l'art connu, testés que partiellement parce que leurs fonctionnements ne peuvent être simulés avec un niveau de résolution suffisamment élevé. Il existe ainsi un vide dans un procédé de test de ceux-ci, qui est tel que :

- On réalise d'abord un test purement électrique en ne prenant pas en compte le capteur, pour vérifier la fonctionnalité, puis
- on effectue un test de l'ensemble, c'est-à-dire de la partie capteur associée à la partie circuit de traitement de l'information délivrée par ce capteur.

L'inconvénient d'un tel procédé est que le test de l'ensemble est entaché d'erreurs liées à la non connaissance précise d'une part des caractéristiques électromécaniques du capteur et d'autre part du signal à mesurer.

L'invention à pour objet un procédé de test permettant de combler un tel vide.

Trois documents de l'art connu sont analysés ci-dessous.

Le brevet US 5,351,519 décrit un circuit pour évaluer la sortie et pour tester un capteur capacitif qui comprend deux commutateurs permettant de sélectionner un mode test et un mode mesure. Dans le mode mesure deux capacitances de mesure, fournies par une électrode centrale et l'une de deux électrodes de mesure, sont connectées à un pont de capacitance. Dans le mode test une des capacitances de mesure est remplacée par une capacitance référence, la capacitance de mesure remplacée étant reliée à une source de tension.

La demande de brevet GB 2 239 096 concerne des circuits de traitement de signal pour des transducteurs piézo-électriques. Afin de tester les conditions de fonctionnement d'un tel transducteur et son circuit de traitement, on injecte des signaux de test au moyen d'un condensateur dans l'ensemble transducteur de telle manière que des mesures hors d'une plage déterminée de fonctionnement puissent être établies sans modifications du transducteur ou du circuit.

Le brevet US 5,103,667 décrit un appareil et un procédé permettant le fonctionnement d'un accéléromètre auto-testable comprenant un boîtier, un diaphragme pour détecter un mouvement en réponse à une force appliquée, une masse sur le diaphragme, au moins une plaque capacitive, attachée au boîtier, disposée de telle sorte qu'une différence de potentiel entre la plaque capacitive et la masse entraîne un mouvement de la masse, des électrodes pour appliquer une différence de potentiel entre la masse et la plaque capacitive, et au moins un élément piézo-électrique attaché au boîtier et au diaphragme pour détecter le mouvement de la masse.

## EXPOSÉ DE L'INVENTION

L'invention concerne un procédé de test d'un système de mesure à capacité variable comprenant une source de tension fixe, un capteur à capacité variable et un circuit de traitement de l'information délivrée par ce capteur, caractérisé en ce qu'il comprend :

- une étape de connexion d'un dispositif électronique d'émulation commandable électriquement, en remplacement du capteur à capacité variable, qui permet de présenter au circuit de traitement une grandeur mesurable,
- une étape de modélisation du comportement électrophysique de ce capteur,
- une étape de test du système.

Avantageusement le procédé de l'invention comprend au cours de l'étape de connexion :

- une étape de connexion d'une capacité de valeur fixe entre la source de tension et le circuit de traitement, et
- une étape de connexion d'une source de tension variable comme source de tension permettant de simuler une variation de capacité dudit capteur, au moyen de variations de tension appliquées à cette capacité.

Avantageusement la valeur de la capacité de valeur fixe est sensiblement égale à la capacité du capteur au repos.

Avantageusement le circuit de traitement comprend un amplificateur opérationnel et une capacité connectée entre son entrée négative et sa sortie et l'information délivrée par la capacité de valeur fixe ou le capteur de capacité variable est fournie sur l'entrée négative de l'amplificateur opérationnel.

Avantageusement le système de mesure à capacité variable est un accéléromètre de type capacitif.

Avantageusement les variations de tension se répercutent sur une variation de charge dans la capacité de valeur fixe, qui est similaire à une variation de la charge causée par une accélération d'un système de mesure à capacité variable.

L'invention concerne également un dispositif de test d'un système de mesure à capacité variable comprenant un système de mesure en mode de fonctionnement normal comprenant une source de tension fixe, un capteur à capacité variable et un circuit de traitement de l'information délivrée par ce capteur dans un mode de fonctionnement normal, caractérisé en ce qu'il comprend un système de mesure en mode de fonctionnement test comprenant une capacité de valeur fixe, une source de tension variable permettant de simuler une variation de capacité dudit capteur au moyen de variations de tension appliquées à cette capacité, et des moyens de commande pour permettre respectivement une connexion du capteur à capacité variable ou de la capacité fixe au circuit de traitement lorsque le dispositif est en mode de fonctionnement normal ou en mode de fonctionnement test.

Avantageusement le circuit de traitement comprend un amplificateur opérationnel et une capacité connectée entre son entrée négative et sa sortie, les moyens de commande étant aptes à connecter la capacité de valeur fixe ou le capteur à capacité variable à l'entrée négative de l'amplificateur opérationnel.

Le procédé de l'invention permet de s'affranchir des incertitudes liées au capteur : caractéristiques électromécaniques précises ou même simple disponibilité, et au phénomène à mesurer : amplitude et fréquence, et calibration de la machine qui génère ce phénomène dans la phase de vérification fonctionnelle de réglage du microsystème, voire même du tri purement électrique de composants après fabrication.

Le procédé de l'invention s'applique, par exemple, au cas d'un accéléromètre capacitif dont la résolution est supérieure à 16 bits ($\sim 1,5.10^{-3}$%) alors que la résolution des dispositifs de test de l'art connu, ponts vibrants par exemple, ne dépasse pas 12 bits ($2,5.10^{-2}$%) Or la vérification des performances d'un accéléromètre 16 bits, dont la pleine échelle de variation de capacité est 1pF, conduit à produire des variations de capacité avec une résolution de l'ordre de 15 atoFarad ($15.10^{-18}$ Farad),alors qu'un pont vibrant précis à 12 bits ne fournit qu'une résolution de l'ordre de 250 atoFarad.

**BRÈVE DESCRIPTION DES DESSINS**

La figure 1 illustre le schéma de principe d'un microsystème de mesure capacitive en mode normal.
La figure 2 illustre le schéma de principe d'un tel microsystème de mesure en mode test, en mettant en oeuvre le procédé de l'invention.
Les figures 3 à 5 illustrent un exemple de mise en oeuvre du procédé de test de l'invention.
La figure 6 illustre un autre exemple de mise en oeuvre du procédé de test de l'invention en mode normal.
La figure 7 illustre un exemple de réalisation d'un dispositif de simulation du capteur capacitif, le circuit de traitement n'étant pas représenté.

**EXPOSÉ DÉTAILLÉ DE MODES DE RÉALISATION PARTICULIERS**

Le procédé de l'invention est un procédé de test pour un microsystème de mesure à capacité variable. Classiquement un tel microsystème comprend une source de tension fixe, un capteur à capacité variable et un circuit de traitement de l'information délivrée par ce capteur.

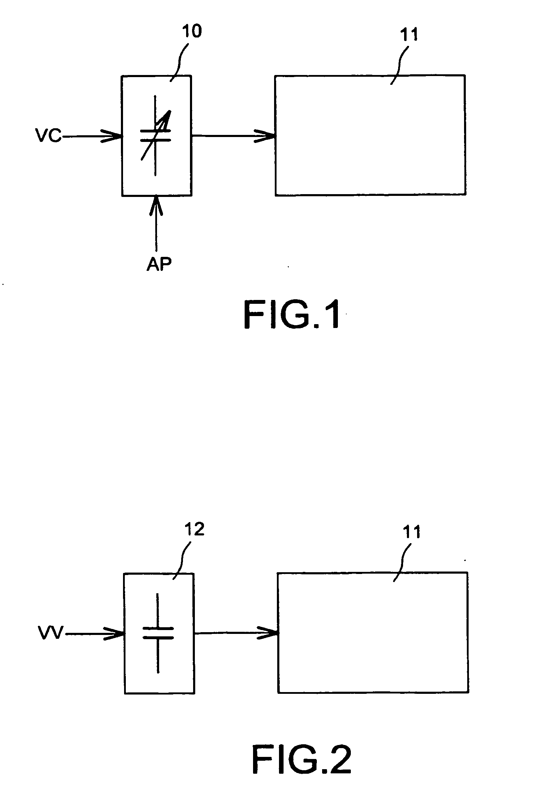

La figure 1 illustre ainsi un microsystème de mesure d'accélération comportant un capteur capacitif 10, un circuit de traitement 11 servant à réaliser la mesure des valeurs de capacité du capteur dans un mode de fonctionnement normal, VC étant une tension d'excitation constante, et AP une accélération physique.

Dans le procédé de l'invention une capacité de valeur fixe est connectée entre la source de tension et le circuit de traitement, cette source de tension étant une source de tension variable.

La figure 2 illustre ainsi la transformation du microsystème illustré dans la figure 1 en mode de test. Le capteur capacitif 10 est remplacé par une capacité de valeur fixe 12 intégrée au circuit ou extérieure. La tension d'excitation constante VC et l'accélération physique AP sont remplacées par une tension d'excitation variable W. Cette tension d'excitation VV est calculée pour que la charge présentée au circuit de traitement 11, en mode test, reste identique à celle qui existe en mode normal, à tension d'excitation constante VC et accélération physique AP données.

Le procédé de l'invention permet de simuler un capteur qui n'est pas utilisable, soit parce qu'il n'est pas disponible, soit parce qu'on ne sait pas le faire fonctionner jusqu'à ses limites.

En effet, autant il est aisé de simuler des variation de tension ou de courant, autant il est difficile de simuler des variations de capacité, d'autant plus que le circuit de traitement ne doit pas être modifié puisqu'il doit être testé dans son état initial. Aussi pour que le dispositif de l'invention ait réellement un comportement capacitif, le capteur capacitif 10 est remplacé par une capacité fixe 12 de valeur à peu près égale à celle du capteur capacitif au repos de manière à préserver ainsi un comportement capacitif, des variations de capacité étant alors simulées au moyen de variations de tension appliquées à cette capacité.

Grâce à de telles caractéristiques la résolution est transférée du domaine des capacités à celui des tensions où il n'y a pas de problème pour atteindre des niveaux de précision très élevés.

De manière plus générale, le but de l'invention est de reporter les variations d'un paramètre physique d'un élément sensible (capacité, résistance, self) sur des variations de tension ou de courant, variations plus simples à obtenir et pouvant être plus précises.

Dans l'exemple illustré sur la figure 2, le circuit de traitement 11 permet de mesurer les valeurs de capacités du capteur par le biais d'une mesure de charge à tension de charge constante. La variation de capacité liée à la variation d'accélération se répercute alors sur une variation de charge. Le capteur peut être remplacé par un dispositif de simulation constitué ici d'une capacité constante, la tension de charge variant de manière à produire une variation de la charge Q (Q=CV) correspondant à la variation d'accélération originale. Le dispositif de simulation permet, alors, par une commande en tension appropriée, de produire le même effet, vu du circuit de traitement 11, que le capteur réel soumis à une accélération donnée.

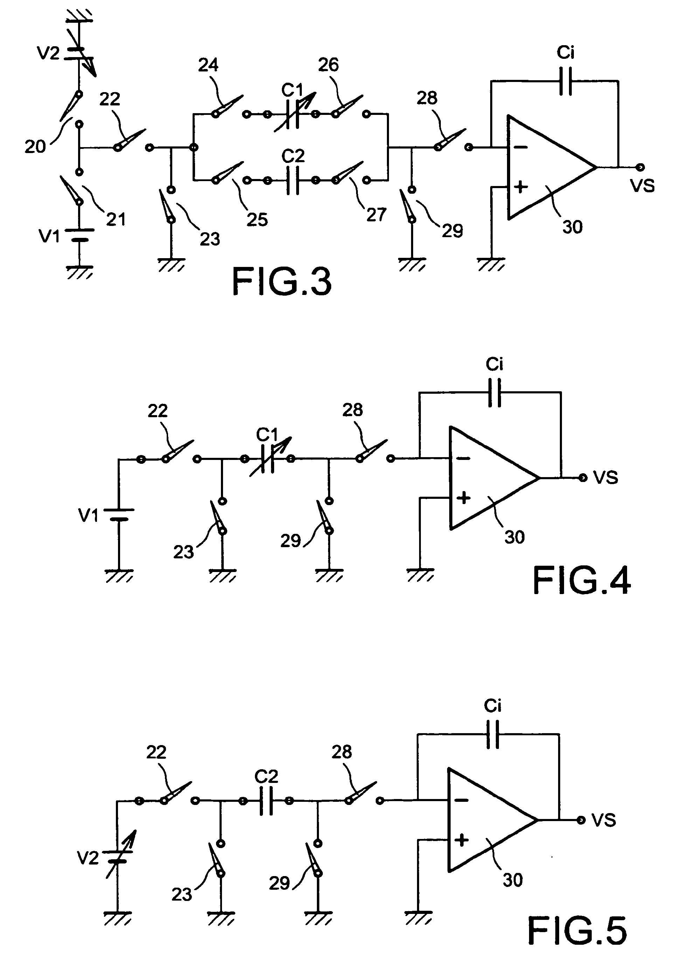

Un exemple de mise en oeuvre du procédé de l'invention est illustré sur la figure 3. Les deux modes de fonctionnement, mode normal et mode test, sont sélectionnés par l'intermédiaire d'interrupteurs 20, 21, 24-27. V1 est une tension constante. V2 est une tension variable. Un amplificateur opérationnel 30 est disposé en sortie, une capacité Ci étant branchée entre son entrée négative et sa sortie. Le mode normal est activé quand le signal test, qui commande les interrupteurs 21, 24 et 26, est valide et le mode test est activé quand le signal test, qui commande les interrupteurs 20, 25 et 27, est valide. C1 correspond au capteur capacitif 10 de la figure 1. C2 correspond à la capacité constante 12 de la figure 2. La sortie de l'amplificateur opérationnel sera l'image (par intégration sur Ci) de la charge stockée par C1 ou C2 en fonction de l'état des interrupteurs 20, 21, 24-27.

Le fonctionnement en mode normal, c'est-à-dire hors mode de test, du circuit de traitement est illustré sur la figure 4. La capacité C1 du capteur est variable et son évaluation est effectuée en intégrant la charge qu'elle contient lorsqu'on lui applique une tension constante V1. Soient Phi1 et phi2 deux phases d'horloges successives non recouvrantes. Lorsque les interrupteurs 22 et 29 validés par la phase phi1 se ferment, la capacité C1 se charge sous la tension constante V1. Dans un second temps, lorsque les interrupteurs 23 et 28 validés par la phase phi2 se ferment, la charge contenue sur C1 est transférée sur la capacité d'intégration Ci, produisant une variation de la tension de sortie VS égale à $\Delta Vout = C1/Ci.Vc$.

Dans le fonctionnement en mode test illustré sur la figure 5, pour reproduire au mieux le comportement du circuit en mode normal, on choisit la valeur de capacité C2 égale à la valeur de capacité C1 du capteur au repos (à accélération nulle). Ensuite, pour simuler une variation de capacité du capteur de $\Delta C1_{max}$ (et surtout la charge correspondante),on choisit V2 tel que :

$$V2_{DC} = V1_{DC}$$

et

$$C2 . \Delta V2_{max} = \Delta C1_{max} . V1$$

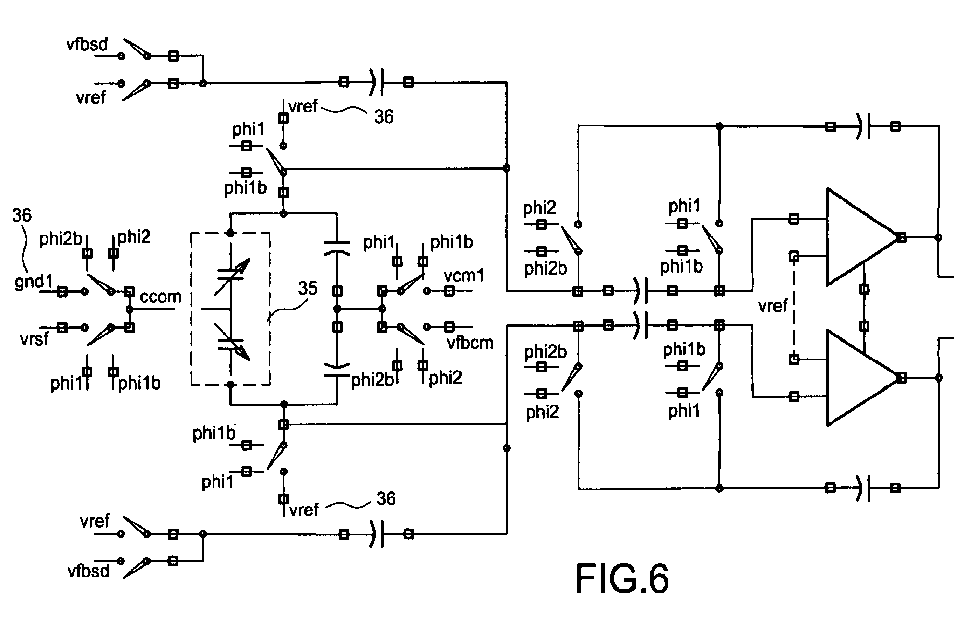

Dans un exemple de réalisation illustré sur la figure 6, le capteur capacitif comporte deux capacités (module 35), chacune ayant son circuit de commande et son circuit de test. Ces deux capacités varient en sens opposé au gré de l'accélération. Le circuit de traitement permet d'évaluer la différence des capacités du capteur par le biais d'une mesure de charge à tension de charge constante. La variation de capacité liée à la variation d'accélération se répercute alors sur une variation de charge. Les tensions 36 sont des tensions fixes de mesure. Tous les « phi » sont les commandes appliquées sur les interrupteurs à différents moments.

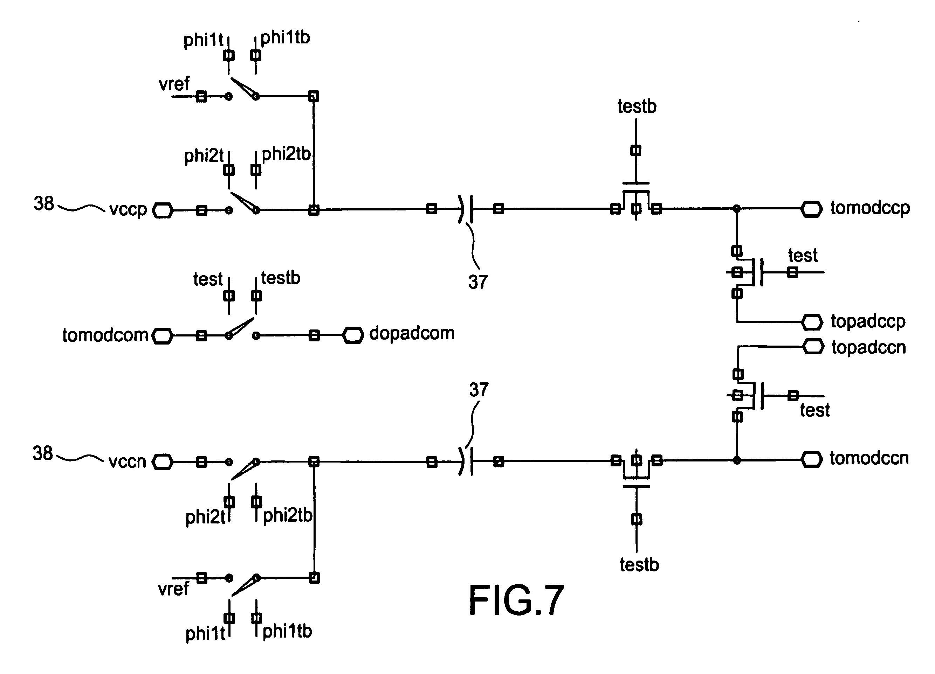

La figure 7 illustre un exemple de mise en oeuvre d'un dispositif de simulation électrique de ce capteur capacitif, qui remplace le module référencé 35 sur la figure 6. Les capacités intégrées 37 sont fixes et les tensions de charge 38 sont variables. Les signaux «test» et «testb» commandent soit la connexion du capteur au circuit dë traitement (connexion des signaux «topadccp» à «tomodccp», «topadccn» à «tomodccn», «topadcom» à «tomodcom») et la déconnexion de dispositif d'émulation électrique de ce même circuit, soit l'inverse, c'est-à-dire la déconnexion du capteur et la connexion du dispositif de simulation électrique.

## Revendications

1.    Procédé de test d'un système de mesure à capacité variable comprenant une source de tension fixe, un capteur à capacité variable (C1) et un circuit de traitement de l'information délivrée par ce capteur, **caractérisé en ce qu'**il comprend :

- une étape de connexion d'un dispositif électronique de simulation commandable électriquement en remplacement du capteur à capacité variable,
- une étape de modélisation du comportement électrophysique de ce capteur,
- une étape de test du système.

2.    Procédé selon la revendication 1, l'étape de connexion comprenant :

- une étape de connexion d'une capacité (C2) de valeur fixe entre la source et le circuit de traitement, et
- une étape de connexion d'une source de tension variable comme source de tension permettant de simuler une variation de capacité dudit capteur, au moyen de variations de tension appliquées à cette capacité.

3.    Procédé selon la revendication 2, dans lequel la valeur de la capacité (C2) de valeur fixe est sensiblement égale à la capacité (C1) du capteur au repos.

**4.** Procédé selon la revendication 2, dans lequel le circuit de traitement comprend un amplificateur opérationnel (30) et une capacité (Ci) connectée entre son entrée négative et sa sortie et dans lequel l'information délivrée par la capacité de valeur fixe (C2) ou le capteur de capacité variable (C1) est fournie sur l'entrée négative de l'amplificateur opérationnel (30).

**5.** Procédé selon la revendication 1, dans lequel le système de mesure à capacité variable est un accéléromètre de type capacitif.

**6.** Procédé selon la revendication 2, dans lequel les variations de tension se répercutent sur une variation de charge dans la capacité de valeur fixe, qui est similaire à une variation de la charge causée par une accélération d'un système de mesure à capacité variable.

**7.** Dispositif de test d'un système de mesure à capacité variable comprenant un système de mesure en mode de fonctionnement normal comprenant une source de tension fixe, un capteur à capacité variable (C1) et un circuit de traitement de l'information délivrée par ce capteur dans un mode de fonctionnement normal, **caractérisé en ce qu'**il comprend un système de mesure en mode de fonctionnement test comprenant une capacité (C2) de valeur fixe, une source de tension variable permettant de simuler une variation de capacité dudit capteur au moyen de variations de tension appliquées à cette capacité, et des moyens de commande pour permettre respectivement une connexion du capteur à capacité variable ou de la capacité fixe au circuit de traitement lorsque le dispositif est en mode de fonctionnement normal ou en mode de fonctionnement test.

**8.** Dispositif selon la revendication 7, dans lequel le circuit de traitement comprend un amplificateur opérationnel (30) et une capacité (Ci) connectée entre son entrée négative et sa sortie, les moyens de commande étant aptes à connecter la capacité (C2) de valeur fixe ou le capteur à capacité variable (C1) à l'entrée négative de l'amplificateur opérationnel (30).

**Patentansprüche**

**1.** Verfahren zum Test eines Mess-Systems mit variabler Kapazität, umfassend eine Konstantspannungsquelle, einen Sensor mit variabler Kapazität (C1) und einen Verarbeitungsschaltkreis zur Verarbeitung der durch den Sensor gelieferten Informationen, **dadurch gekennzeichnet, dass** es umfasst:

- einen Schritt des Anschließens einer elektrisch steuerbaren/regelbaren elektronischen Simulationseinrichtung als Ersatz für den Sensor mit variabler Kapazität,
- einen Schritt des Modellierens von dem elektrophysikalischen Verhalten des Sensors,
- einen Schritt des Testens von dem System.

**2.** Verfahren nach Anspruch 1, wobei der Schritt des Anschließens umfasst:

- einen Schritt des Anschließens von einer Kapazität (C2) mit festem Wert zwischen der Quelle und dem Verarbeitungsschaltkreis, und
- einen Schritt des Anschließens einer Quelle für variable Spannung als Spannungsquelle, was es ermöglicht, eine Variation der Kapazität von dem Sensor vermittels Variationen der an die Kapazität angelegten Spannung zu simulieren.

**3.** Verfahren nach Anspruch 2, wobei der Wert der Kapazität (C2) mit festem Wert im Wesentlichen gleich der Kapazität (C1) des Sensors im Ruhezustand ist.

**4.** Verfahren nach Anspruch 2, wobei der Verarbeitungsschaltkreis einen Operationsverstärker (30) und eine Kapazität (Ci) umfasst, die zwischen dessen negativem Eingang und dessen Ausgang angeschlossen ist, und wobei die Informationen, die durch die Kapazität mit festem Wert (C2) oder durch den Sensor mit variabler Kapazität (C1) geliefert werden, an den negativen Eingang von dem Operationsverstärker (30) geliefert werden.

**5.** Verfahren nach Anspruch 1, wobei das Mess-System mit variabler Kapazität ein Beschleunigungs-Messgerät vom kapazitiven Typ ist.

**6.** Verfahren nach Anspruch 2, wobei die Variationen der Spannung sich in einer Variation der Ladung in der Kapazität mit festem Wert niederschlagen, die ähnlich ist zu einer Variation der Ladung, die durch eine Beschleunigung von einem Mess-System mit variabler Kapazität bewirkt wird.

**7.** Vorrichtung zum Test eines Mess-Systems mit variabler Kapazität, umfassend ein System zum Messen in einem Normal-Funktionsmodus, welches eine Konstantspannungsquelle, einen Sensor mit variabler Kapazität (C1) und einen Verarbeitungsschaltkreis umfasst, um Informationen zu verarbeiten, die in einem Normal-Funktionsmodus durch den Sensor geliefert werden, **dadurch gekennzeichnet, dass** sie ein System zum Messen in einem Test-Funktionsmodus umfasst, welches eine Kapazität (C2) mit festem Wert, eine variable Spannungsquelle, welche es ermöglicht, eine Variation der Kapazität des Sensors durch Variationen der an diese Kapazität angelegten Spannung zu simulieren, und Steuer-/Regelmittel umfasst, um eine Verbindung des Sensors mit variabler Kapazität bzw. der festen Kapazität mit dem Verarbeitungs-Schaltkreis zu ermöglichen, wenn sich die Einrichtung im Normal-Funktionsmodus bzw. im Test-Funktionsmodus befindet.

8. Einrichtung nach Anspruch 7, wobei der Verarbeitungsschaltkreis einen Operationsverstärker (30) und eine Kapazität (Ci) umfasst, die zwischen dessen negativem Eingang und dessen Ausgang angeschlossen ist, wobei die Steuer-/Regelmittel dazu angepasst sind, die Kapazität (C2) mit festem Wert oder den Sensor mit variabler Kapazität (C1) am negativen Eingang von dem Operationsverstärker (30) anzuschließen.

**Claims**

1. A test method for variable capacitance measuring system comprising a fixed voltage source, a variable capacitance sensor (C1) and a processing circuit to process the data delivered by this sensor, **characterized in that** it comprises:

   - a step to connect an electrically controllable electronic simulation device to replace the variable capacitance sensor;
   - a step to model the electro-physical behaviour of this sensor;
   - a step to test the system.

2. The method according to claim 1, the connection step comprising:

   - a step to connect a capacitor (C2) of fixed value between the source and the processing circuit; and
   - a step to connect a variable voltage source as voltage source allowing the simulation of a variation in capacitance of the said sensor, by means of variations in voltage applied to this capacitor.

3. The method according to claim 2 wherein the capacitance value of the capacitor (C2) of fixed value is substantially equal to the capacitance of the sensor (C1) at rest.

4. The method according to claim 2, wherein the processing circuit comprises an operational amplifier (30) and a capacitor (Ci) connected between its negative input and its output, and wherein the data delivered by the fixed value capacitor (C2) or the variable capacitance sensor (C1) is delivered onto the negative input of the operational amplifier (30).

5. The method according to claim 1, wherein the variable capacitance measuring system is an accelerometer of capacitive type.

6. The method according to claim 2, wherein the variations in voltage impact a variation in load in the fixed value capacitor, which is similar to a variation in load caused by acceleration of a variable capacitance measuring system.

7. A device for testing a variable capacitance measuring system comprising a measuring system in normal operating mode comprising a fixed voltage source, a variable capacitance sensor (C1) and a processing circuit to process the data delivered by this sensor in normal operating mode, **characterized in that** it comprises a measuring system in test operating mode comprising a fixed value capacitor (C2), a variable voltage source allowing simulation of a variation in capacitance of the said sensor by means of variations in voltage applied to this capacitor, and control means respectively to allow connection of the variable capacitance sensor or of the fixed value capacitor to the processing circuit when the device is in normal operating mode or in test operating mode.

8. The device according to claim 7, wherein the processing circuit comprises an operational amplifier (30) and a capacitor (Ci) connected between its negative input and its output, the control means being capable of connecting the fixed value capacitor (C2) or the variable capacitance sensor (C1) to the negative input of the operational amplifier (30).

10

11

VC →

AP ↑

# FIG.1

12

11

VV →

# FIG.2

FIG.3

FIG.4

FIG.5

FIG.6

EP 1 766 338 B1

FIG.7

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 5351519 A
- GB 2239096 A
- US 5103667 A